# EUROPEAN PATENT APPLICATION

(11) **EP 4 576 156 A2**
(43) Date of publication of application: **25.06.2025**
(21) Application number: 24212480.8
(22) Date of filing: 12.11.2024
(51) Int. Cl.: H01J 37/24, H01J 37/26

(54) **COOLING APPARATUS AND COOLING PREPARATION METHOD**

(30) Priority: 20.12.2023 JP 2023214426
(71) Applicant: Jeol Ltd., Akishima-shi, Tokyo 196-8558 (JP)
(72) Inventor: HAMOCHI, Mitsuru, Tokyo 196-8558 (JP)
(74) Representative: Boult Wade Tennant LLP

(57) **Abstract**

A pressure control equipment (16) changes a pressure in a tank (12) from an initial pressure (atmospheric pressure) to a first pressure (negative pressure), so as to cause a liquid coolant from an external container (14) to be injected into the tank (12) (S18). After a certain amount of the liquid coolant is injected into the tank (12) (S20), the pressure control equipment (16) causes the pressure in the tank to change from the first pressure to a second pressure (atmospheric pressure) (S22). Then, after a settling period, spontaneous bumping is caused in the liquid coolant in the tank (12) (S26). Due to the spontaneous bumping, the pressure in the tank (12) is rapidly, temporarily increased, and bubbles in the liquid coolant in the tank (12) liquefy. With this process, cavities are deactivated.

## Description

### TECHNICAL FIELD

The present disclosure relates to a cooling apparatus and a cooling preparation method, and in particular to a cooling apparatus having a tank which stores a liquid coolant.

### BACKGROUND

A cooling apparatus is an apparatus for cooling a member to be cooled. The cooling apparatuses are used in various fields. For example, in observation of a sample using a transmission electron microscope, the cooling apparatus is used to maintain the sample at a very low temperature, or to maintain a gas molecule trap at a very low temperature. The gas molecule trap is used for preventing contamination of the sample or improve the degree of vacuum. In general, the cooling apparatus has a tank which stores a liquid coolant such as liquid nitrogen (for example, refer to JP H5-45012 Y).

When the liquid coolant in the tank absorbs heat from outside, the liquid coolant boils. More specifically, the heat from the outside is conducted to the liquid coolant via an inner surface of the tank. On the inner surface of the tank, minute scratches, recesses, or the like are present in a non-ignorable number. It is known that bubbles tend to be generated easily and repeatedly at such scratches and recesses. These scratches and recesses are called "cavities".

More specifically, due to the heat from the outside, the liquid coolant is vaporized in the cavity, and minute bubbles are generated. When a bubble grows into a large bubble, the bubble detaches from the cavity, and moves (floats) upward. After the large bubble detaches from the cavity, a minute bubble remains in the cavity. The minute bubble then grows into a large bubble. Once a bubble is generated in the cavity, bubbles tend to be generated repeatedly.

The repeated generation of the bubbles in the tank causes the tank to vibrate. In particular, repeated generation of the bubbles at a lower part of the tank causes significant vibration of the tank. The vibration of the tank adversely affects apparatuses to which the tank is connected. For example, when the tank is connected to a transmission electron microscope, the vibration is transmitted from the tank to the transmission electron microscope, and becomes a significant obstacle for sample observation.

An advantage of the present disclosure lies in reduction of vibration of a tank which stores a liquid coolant. Alternatively, an advantage of the present disclosure lies in deactivating a cavity on an inner surface of the tank which stores a liquid coolant.

### SUMMARY

According to one aspect of the present disclosure, there is provided a cooling apparatus comprising: a tank connected to a member to be cooled via a heat conducting member; and pressure control equipment that includes a pump which suctions gas in the tank, and that sets a pressure in the tank to a first pressure during a first period in which a liquid coolant is injected into the tank, and sets the pressure in the tank to a second pressure higher than the first pressure during a second period subsequent to the first period, so that spontaneous bumping is caused in the liquid coolant in the tank during the second period.

According to another aspect of the present disclosure, there is provided a cooling method comprising: a first step of reducing a pressure in a tank connected to a member to be cooled via a heat conducting member, from an initial pressure to a first pressure, to thereby lower a boiling point of a liquid coolant injected into the tank; a second step of increasing, after the first step, the pressure in the tank from the first pressure to a second pressure, to thereby increase the boiling point of the liquid coolant in the tank; and a third step in which, after the second step, spontaneous bumping is caused in the liquid coolant in the tank with an increase of a temperature of the liquid coolant in the tank, so that bubbles in the liquid coolant in the tank liquefy.

### BRIEF DESCRIPTION OF DRAWINGS

Embodiment(s) of the present disclosure will be described based on the following figures, wherein:
FIG. 1 is a diagram showing an example structure of a cooling apparatus according to an embodiment of the present disclosure;
FIG. 2 is a diagram showing an example placement of the cooling apparatus according to the embodiment of the present disclosure;
FIG. 3 is a diagram showing generation of bubbles generated in a cavity;
FIG. 4 is a diagram showing an example operation of the cooling apparatus according to the embodiment of the present disclosure;
FIG. 5 is a diagram showing a change of temperature and a change of pressure during a cooling preparation process; and
FIG. 6 is a diagram showing a cooling apparatus of the related art.

### DESCRIPTION OF EMBODIMENTS

An embodiment of the present disclosure will now be described with reference to the drawings.

### (1) Overview of Embodiment

A cooling apparatus according to an embodiment of the present disclosure comprises a tank and pressure control equipment. The tank is connected to a member to be cooled via a heat conducting member. The pressure control equipment has a pump which suctions gas in the tank. The pressure control equipment sets a pressure in the tank to a first pressure during a first period in which a liquid coolant is injected into the tank. The pressure control equipment further sets the pressure in the tank to a second pressure higher than the first pressure during a second period subsequent to the first period, so that spontaneous bumping is caused in the liquid coolant in the tank during the second period.

According to the above-described structure, desirably, a boiling point of the liquid coolant in the tank is reduced during the first period. That is, the temperature of the liquid coolant in a boiled state is reduced. In the subsequent second period, the pressure in the tank is increased, so that the boiling point of the liquid coolant in the tank is increased. That is, boiling of the liquid coolant is temporarily suppressed. After such a temporary settling process, with an increase in the temperature of the liquid coolant due to heat flowing in from the outside, the temperature of the liquid coolant again reaches the boiling point in the tank. However, because the inflow of the heat is relatively gradual, the boiling of the liquid coolant does not occur immediately, and a part of the liquid coolant is placed in an overheated state. Then, with a small vibration or the like as a trigger, the part of the liquid coolant in the overheated state vaporizes at once; that is, vigorous boiling (bumping) is caused. This phenomenon is the spontaneous bumping described above.

The spontaneous bumping significantly increases the pressure in the tank for a short period of time. A rapid increase of the pressure causes the bubbles in the liquid coolant to liquefy. That is, the bubbles in the cavity disappear, and repeated generation of the bubbles in the cavity is stopped. That is, the cavity is deactivated.

After the spontaneous bumping occurs, if a large amount of heat flows into the liquid coolant, the cavity is again activated. Thus, desirably, a thermal equilibrium is formed between the tank and the member to be cooled before the last spontaneous bumping. Even if the heat flows into the liquid coolant from the outside after the thermal equilibrium is reached, if the amount of heat is small or if the heat flows into an upper part of the liquid coolant in the tank, normally, the vibration due to the boiling of the liquid coolant is small, and the problem due to the vibration basically does not occur. The first pressure and the second pressure described above are pressures which are set by the pressure control equipment, and correspond to baselines. Due to the boiling of the liquid coolant (including bumping), a pressure peak is superposed on the baseline.

In an embodiment, the first pressure is a pressure lower than an atmospheric pressure. The second pressure is the atmospheric pressure. In this structure, first, the pressure in the tank is set to a negative pressure, and the pressure in the tank is then returned to the atmospheric pressure. With the use of the atmospheric pressure, the structure of the pressure control equipment can be simplified, and the control of the pressure can be facilitated. In the embodiment, the pressure in the tank is changed from the initial pressure (atmospheric pressure) to the first pressure at the start of the first period.

In order to cause the spontaneous bumping in the liquid coolant presuming the inflow of the heat from the outside, a manipulation to increase the boiling point of the liquid coolant from a first temperature to a second temperature is important. Thus, the first temperature may be set at an arbitrary temperature, and the second temperature may be set with reference to the first temperature.

The cooling apparatus according to an embodiment further comprises a sensor that detects a liquid surface height of the liquid coolant in the tank. Based on an output signal of the sensor, the pressure control equipment determines a timing of changing the pressure in the tank to the second pressure. A part of the liquid coolant injected into the tank is vaporized by the boiling. It is difficult to identify a liquid surface level (amount of liquid) of the liquid coolant in the tank based on an amount of supply of the liquid coolant. According to the above-described structure, it becomes possible to control the pressure in the tank based on an actual liquid surface height of the liquid coolant.

The cooling apparatus according to the embodiment further comprises an external container into which the liquid coolant is injected, and a supply pipe through which the liquid coolant in the external container is sent to the tank. The first pressure is a pressure lower than an atmospheric pressure. The liquid coolant in the external container is introduced into the tank via the supply pipe during the first period. According to this structure, the liquid coolant is naturally introduced into the tank through the negative pressure in the tank. Therefore, the injection operation of the liquid coolant can be facilitated. The negative pressure is a pressure lower than the atmospheric pressure.

In an embodiment, the external container is placed at a position lower than the tank.

According to this structure, a filling operation of the liquid coolant to the external container can be facilitated. By avoiding an operation at a high location, safety of a worker can be improved.

In an embodiment, a porous member is provided at an intake port of the supply pipe. According to this structure, several advantages can be obtained. First, the porous member can function as a filter. That is, intrusion of foreign objects such as ice into the tank can be prevented. Secondly, if gas generated in the tank flows out from the porous member in a state in which the porous member is exposed, the surface of the porous member is covered by the gas. With this configuration, intrusion of air into the supply pipe can be blocked. Thirdly, because a flow path resistance is increased by the porous member, a large pressure increase can be caused in the tank at the time of occurrence of the spontaneous bumping without providing an open/close valve midway on the supply pipe and closing the valve.

In an embodiment, the pressure control equipment includes a suctioning pipe provided between the pump and the tank, and a detector which detects a temperature at a detection position on the suctioning pipe. Overflow of the liquid coolant from the tank is judged based on the temperature detected by the detector. According to this structure, the overflow of the liquid coolant can be judged with a simple structure. In an embodiment to be described below, a control unit functions as an overflow judgment device.

In an embodiment, the pressure control equipment includes a relief valve which operates when the pressure in the tank reaches a predetermined pressure. The relief valve operates when the pressure in the tank becomes higher than a predetermined value (upper limit value), exceeding a pressure which allows deactivation of the cavity. According to this structure, the degree of safety can be improved.

A cooling preparation method according to an embodiment of the present disclosure comprises a first step, a second step, and a third step. In the first step, a pressure in a tank connected to a member to be cooled via a heat conducting member is reduced from an initial pressure to a first pressure. With this process, a boiling point of a liquid coolant injected into the tank is lowered. In the second step, after the first step, the pressure in the tank is increased from the first pressure to the second pressure. With this process, the boiling point of the liquid coolant in the tank is increased, and boiling of the liquid coolant in the tank is temporarily suppressed. In the third step, after the second step, spontaneous bumping is caused in the liquid coolant in the tank with an increase of a temperature of the liquid coolant in the tank. With this process, bubbles in the liquid coolant in the tank liquefy. That is, the cavity on the inner surface of the tank is deactivated. By suppressing the repeated generation of the bubbles in the liquid coolant in the tank, it is possible to reduce the vibration caused in the tank in a cooling state of the member to be cooled.

### (2) Details of Embodiment

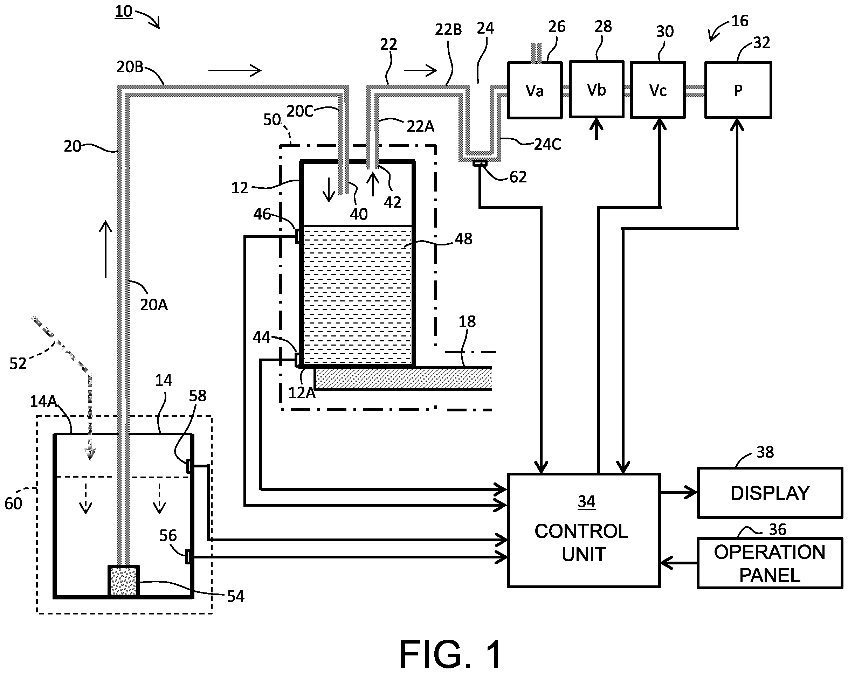

FIG. 1 schematically shows an example structure of a cooling apparatus according to an embodiment of the present disclosure. A cooling apparatus according to the embodiment of the present disclosure is, for example, an apparatus for cooling a member to be cooled included in an electron microscope. Alternatively, the cooling apparatus according to the embodiment may be used for other usages. In an embodiment of the present disclosure, a liquid coolant is specifically liquid nitrogen. Alternatively, other liquid coolants may be used.

In FIG. 1, the cooling apparatus 10 comprises a tank 12, an external container 14, pressure control equipment 16, a supply pipe 20, and a suctioning pipe 22. The tank 12 is a tank which stores liquid nitrogen. A side wall of the tank 12 is formed from, for example, stainless steel, and a bottom wall of the tank 12 is formed from, for example, copper. The tank 12 has a vacuum heat-insulation structure 50.

A bottom surface 12A of the tank 12 is connected to a heat conducting member 18. The heat conducting member 18 is connected to a member to be cooled (not shown). The heat conducting member 18 is formed from, for example, a copper plate, a copper mesh wire, or the like. The member to be cooled is a sample, a gas molecule trap, or the like.

A temperature sensor 44 is provided on an outer surface of the tank 12 at a lower part thereof. A temperature sensor 46 is provided on the outer surface of the tank 12 at an upper part thereof. With reference to an inner bottom surface height of the tank 12, the temperature sensor 44 is placed at a first height, and the temperature sensor 46 is placed at a second height. The second height is a reference height for determining a timing to judge stopping of supply of liquid nitrogen. The temperature sensor 44 is provided in order to detect presence or absence of liquid nitrogen in the tank 12. A control unit 34 to be described below judges that a liquid surface of liquid nitrogen has reached or exceeded the second height based on an output signal of the temperature sensor 46.

The external container 14 is a dewar which stores liquid nitrogen. The external container 14 has a vacuum heat-insulation structure or a heat-insulation member 60. The external container 14 has an opening 14A, through which liquid nitrogen is injected into the external container 14 (refer to reference numeral 52). A temperature sensor 56 is provided on an inner surface of the external container 14 at a lower part thereof, and a temperature sensor 58 is provided on the inner surface of the external container 14 at an upper part thereof. Specifically, with reference to the inner bottom surface height of the external container 14, the temperature sensor 56 is provided at a third height, and the temperature sensor 58 is provided at a fourth height. Alternatively, the temperature sensors 56 and 58 may be provided on an outer surface of the external container 14.

The temperature sensor 56 is provided in order to judge that liquid nitrogen is present in the external container 14 in an amount greater than or equal to a certain amount. More specifically, the temperature sensor 56 is for confirming that the liquid surface of liquid nitrogen is at a position higher than an upper surface of a porous member 54 to be described later. The temperature sensor 58 is provided for preventing overflow of liquid nitrogen from the external container 14.

A heat-insulation member is provided at an outer side of the supply pipe 20, but illustration thereof is omitted. The supply pipe 20 has a first portion 20A which extends along a vertical direction, a second portion 20B which extends along a horizontal direction, and a third portion 20C which extends along the vertical direction.

A lower end opening (intake port) of the first portion 20A is covered with the porous member 54. The porous member 54 has a large number of minute pores, each of which permits passage of liquid and gas. The porous member 54 is formed from, for example, a sintered metal. Alternatively, the porous member 54 may be formed from a ceramic or the like.

The porous member 54 functions as a filter. That is, passage of a foreign object such as ice is blocked by the porous member 54. In addition, the porous member 54, together with a small inner size of the supply pipe 20, contributes to an increase of a flow path resistance. After liquid nitrogen is injected into the tank 12, nitrogen gas from the tank flows from a surface of the porous member 54 to the outside. When the amount of liquid nitrogen in the external container 14 becomes low, the porous member 54 is exposed. However, because the porous member 54 is enclosed by the nitrogen gas, intrusion of air into the supply pipe 20 is blocked. At the same time, dew formation and frost formation on the surface of the porous member 54 are prevented.

As illustrated, the external container 14 is placed at a position lower than the tank 12. More specifically, a bottom wall of the external container 14 is placed at a position lower than a bottom wall of the tank 12. Although it is possible to inject liquid nitrogen into the tank 12 from a position higher than the tank 12, in such a configuration, an operation at a high location by a worker is necessary. According to the structure of the embodiment, because the worker only needs to perform the operation at a low location, burden of the worker can be reduced, and the safety of the worker can be improved.

A lower end 40 of the third portion 20C of the supply pipe 20 extends into the tank 12. The lower end 40 functions as an ejection nozzle.

The suctioning pipe 22 has a first portion 22A which extends along the vertical direction, a second portion 22B which extends along the horizontal direction, and a U-shaped portion 24C which belongs to a detector 24. A heat-insulation member is provided as necessary also on an outer side of the suctioning pipe 22. The U-shaped portion 24C is formed from a portion which extends downward, a portion which is curved, and a portion which extends upward. At downstream of the U-shaped portion 24C, a plurality of devices are placed, details of which are to be described below. A lower end 42 of the first portion 22A extends into the tank 12, and functions as a suctioning nozzle.

The detector 24 detects overflow of liquid nitrogen from the tank 12. The detector 24 has a temperature sensor 62 provided on an outer surface of a bottom portion (bottom surface) of the U-shaped portion 24C. When liquid nitrogen enters the U-shaped portion 24C, a temperature detected by the temperature sensor 62 is rapidly reduced. Based on this, the control unit 34 to be described later judges the occurrence of overflow. The U-shaped portion 24C is formed from a material with superior thermal conductivity (for example, copper).

Next, the pressure control equipment 16 will be described. The pressure control equipment 16 has a relief valve 26, a flow rate adjustment valve 28, an open/close valve (electromagnetic valve) 30, and a vacuum pump 32, and additionally has the control unit 34 which controls operations of these components.

The relief valve 26 is a safety valve. The relief valve 26 is normally in a closed state, and is automatically opened when a pressure in the suctioning pipe 22; that is, the pressure in the tank 12, has reached a predetermined pressure (upper limit value). The predetermined pressure is, for example, 0.03 MPa (0.3 atmospheres). Alternatively, the relief valve 26 may be provided at another position, so long as the function thereof is realized. The flow rate adjustment valve 28 is a valve for adjusting a flow rate of gas flowing in the suctioning pipe 22, and, in the embodiment, the flow rate adjustment valve 28 functions during a suctioning process.

The vacuum pump 32 is a suctioning apparatus for suctioning gas in the tank 12, and reducing the pressure in the tank 12 to a pressure lower than the atmospheric pressure. The vacuum pump may be operated only during the suctioning, or the vacuum pump 32 may be operated at all times. Alternatively, a buffer tank may be provided upstream of the vacuum pump 32. Various pumps may be used as the vacuum pump 32. Alternatively, a pump for vacuuming a lens barrel of a transmission electron microscope may be used as the vacuum pump 32.

The control unit 34 is formed from a computer, a microcomputer, or the like. More specifically, the control unit 34 is formed from a processor which executes a program. The control unit 34 controls operations of the open/close valve 30 and operations of the vacuum pump 32. Alternatively, the control unit 34 may further control operations of the flow rate adjustment valve 28. Output signals from the temperature sensors 44, 46, 56, 58, and 62 are input to the control unit 34. The control unit 34 controls operations of the cooling apparatus 10 based on these output signals.

More specifically, the control unit 34 judges that liquid nitrogen is present in the tank 12 based on the output signal of the temperature sensor 44. In addition, the control unit 34 judges that the liquid surface of liquid nitrogen has reached the second height based on the output signal of the temperature sensor 46. As will be described later, the control unit 34 changes the pressure in the tank from the first pressure (negative pressure) to the second pressure (atmospheric pressure) at a timing when a predetermined time has elapsed from a timing of judgment of reaching of the liquid surface. The control unit 34 judges overflow of liquid nitrogen based on the output signal of the temperature sensor 62. When liquid nitrogen has overflown, an alert is output.

The control unit 34 judges that liquid nitrogen is present in the external container 14 in an amount greater than or equal to a certain amount, based on the output signal of the temperature sensor 56. The control unit 34 performs the supply of liquid nitrogen from the external container 14 to the tank 12 only when liquid nitrogen is present in the external container 14 in the certain amount. The control unit 34 judges that the liquid surface of liquid nitrogen has reached the fourth height (upper limit of liquid surface height) based on the output signal of the temperature sensor 58. In this case, an alert is output.

An operation panel 36 which is an inputting device is connected to the control unit 34, and a display 38 is connected to the control unit 34. The operation panel 36 includes a plurality of switches, a plurality of buttons, or the like. The display 38 is formed from, for example, a liquid crystal display.

The supply pipe 20 is relatively long, and the inner size of the supply pipe 20 is relatively small. Further, the porous member 54 is provided on the intake port of the supply pipe 20. Therefore, the flow path resistance of the supply pipe 20 is large. The open/close valve 30 is provided on the suctioning pipe 22. When the open/close valve 30 is in the closed state, the inside of the tank 12 is close to a closed space. In this state, a rapid pressure increase in a short period of time is caused in the tank 12, due to spontaneous bumping to be described below. From another perspective, a length and an inner size of the supply pipe 20, a porosity of the porous member 54, and the like, are determined in such a manner that the pressure increase as described above occurs.

When moisture enters the tank 12 and ice is generated in the tank, a relatively large bubble tends to be more easily generated due to the ice. In consideration of this, a heater (not shown) is provided at an outer side of the tank 12 at the bottom thereof. Prior to the supply of the liquid coolant, electricity is applied to the heater as necessary, so that the moisture in the tank 12 is released to the outside as water vapor. A heater (not shown) is also provided at an outer side of the external container 14 at an upper part thereof. When frost or ice is attached to the upper part of the external container 14, the frost or ice attached to the upper part of the external container 14 can be removed by applying electricity to the heater.

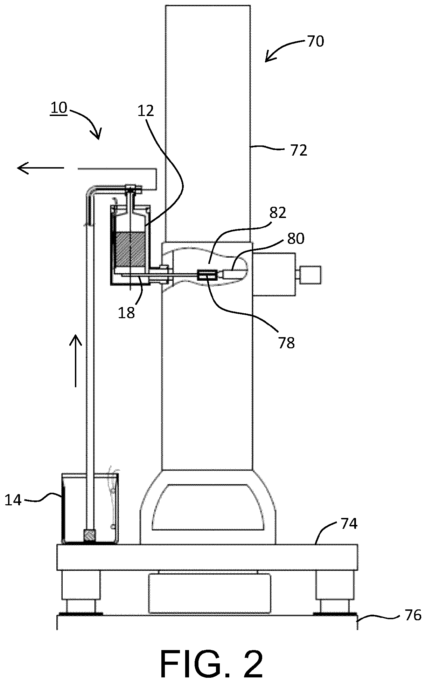

FIG. 2 shows an example placement of the cooling apparatus according to the embodiment of the present disclosure. A transmission electron microscope 70 has a lens barrel 72 which extends in a vertical direction (up-and-down direction). In the lens barrel 72, an electron gun, a condensing lens, an objective lens, a sample chamber, and the like are provided. A sample 78 which is an observation target is held by a sample holder 80. A gas molecule trap 82 is provided near the sample 78. The gas molecule trap 82 is provided for trapping contaminant substances, to prevent contamination of the sample, and for increasing the degree of vacuum in the sample chamber.

A cooling target of the cooling apparatus 10 is the gas molecule trap 82. The tank 12 is connected to the gas molecule trap via the heat conducting member 18. The gas molecule trap 82 is fixed in the sample chamber via a member having low thermal conductivity (for example, glass).

The transmission electron microscope 70 has a base (horizontal plate) 74 supported by a pedestal 76. The external container 14 is placed on the base 74. The supply pipe provided between the external container 14 and the tank 12 has a portion which is elongated along the vertical direction. In FIG. 2, illustration of the pressure control equipment is omitted.

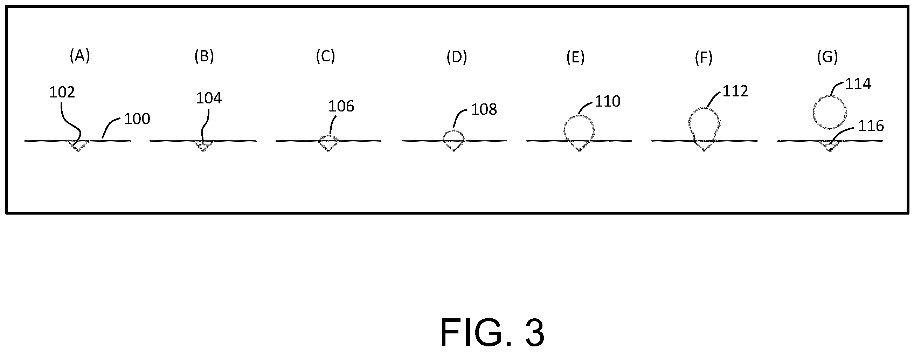

FIG. 3 shows an action of the cavity. The process of growth of the bubble is shown in steps, by (A) to (G). A very small recess (cavity) 102 is present on a tank inner surface 100. A small bubble 104 is generated in the cavity. The bubble gradually grows (refer to reference numerals 106, 108, 110, and 112). As shown by (G), a bubble 114 after the growth detaches from the cavity, and moves upward. In this process, a small bubble 116 remains in the cavity. The bubble 116 becomes an origin of a next large bubble. Once a bubble is generated in the cavity, the bubble generation is repeated.

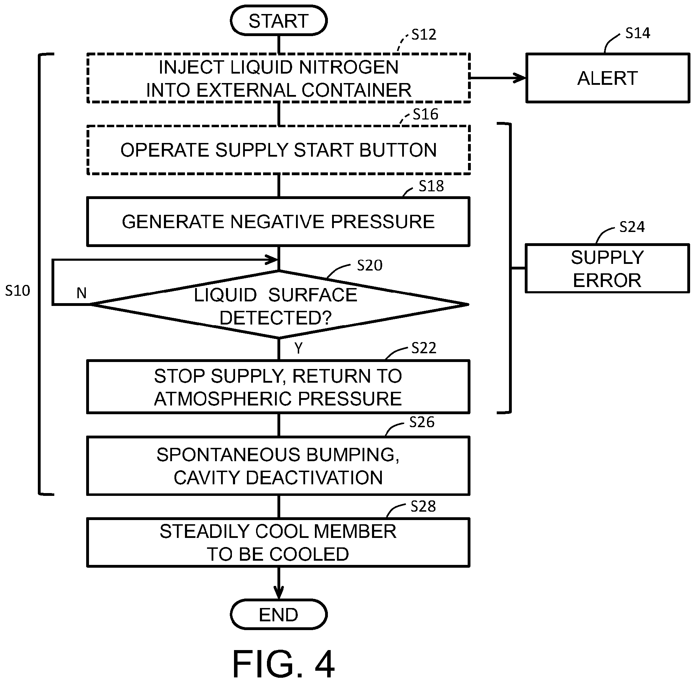

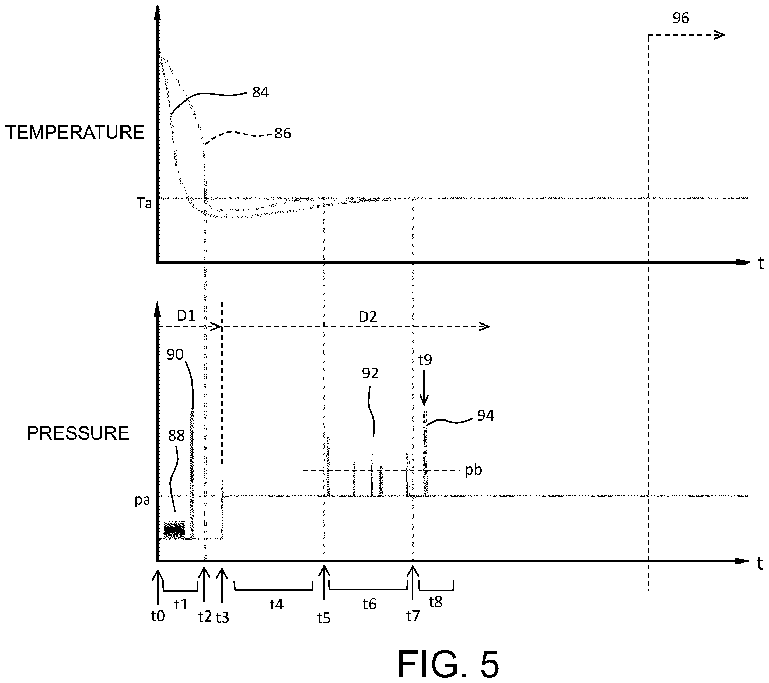

FIG. 4 shows an example operation of the cooling apparatus according to the embodiment of the present disclosure, as a flowchart. FIG. 5 shows a change of temperature of the liquid coolant and a change of the pressure in the tank during a cooling preparation process. First, the example operation will be described, and then, the change of the temperature and the change of the pressure will be described in detail.

In an initial state, the tank is empty, or the liquid coolant is present in the tank in an uncertain amount. The pressure in the tank at the initial state (initial pressure) is the atmospheric pressure. In the following, for the convenience of the description, a situation is presumed in which the tank is empty in the initial state.

In FIG. 4, S10 shows a cooling preparation process, and S28 shows a cooling process. First, in S12, a worker injects liquid nitrogen of a predefined amount into the external container. When the liquid surface height of liquid nitrogen exceeds the upper limit height (or when a predetermined time has elapsed from the time when the liquid surface height exceeds the upper limit), in S14, an alert (sound, light, image, or the like) is output. After liquid nitrogen in the predefined amount is injected into the external container, in S16, the worker operates a supply start button in the operation panel.

When the supply start button is operated in a state in which the vacuum pump is operating, the control unit opens the open/close valve. With this process, the pressure in the tank changes from the initial pressure (atmospheric pressure) to a first pressure (negative pressure). The first pressure can be adjusted by changing an amount of operation of the flow rate adjustment valve. When the liquid surface height of liquid nitrogen in the external container is lower than a first liquid surface height (lower limit), the supply of liquid nitrogen is not started. If a similar situation occurs in the middle of supply of liquid nitrogen, the supply of liquid nitrogen is stopped.

When the pressure in the tank changes from the atmospheric pressure to the first pressure, the liquid coolant in the external container starts to move to the tank. In a state in which the supply pipe or the tank is not sufficiently cooled, liquid nitrogen first vigorously vaporizes in the supply pipe, and, then, even if liquid nitrogen enters the tank, liquid nitrogen entering the tank vigorously vaporizes. When atmospheric air is contained in the tank, nitrogen gas caused by the vaporization pushes the atmospheric air out, and the atmospheric air in the tank is replaced with the nitrogen gas. With this process, the water vapor contained in the atmospheric air is released to the outside. If the pressure in the tank exceeds a predefined pressure due to the vaporization of liquid nitrogen, the relief valve operates automatically. After the supply pipe and the tank are cooled to a certain degree, liquid nitrogen starts to accumulate in the tank.

In S20, it is detected that the liquid surface of liquid nitrogen in the tank has reached the second height (predefined height). In S22, the control unit stops the supply of liquid nitrogen at a timing after a predetermined time has elapsed from the detection of the liquid surface height reaching the second height. Specifically, the control unit closes the open/close valve. With this process, the pressure in the tank changes from the first pressure to the second pressure (atmospheric pressure).

Then, after a certain settling period, in S26, normally, the spontaneous bumping occurs a plurality of times in the liquid coolant in the tank. A mechanism of occurrence of the spontaneous bumping will be described later in detail. Due to the spontaneous bumping, typically a relatively large spontaneous bumping which occurs at a last stage, the pressure in the tank is rapidly, temporarily increased, and bubbles included in the liquid coolant liquefy. In experiments, it was confirmed that bubbles liquefy with a pressure increase of greater than or equal to 0.005 MPa (0.05 atmospheres). With this process, the cavity present on the inner surface of the tank is deactivated. Repeated generation of the bubbles due to the cavity stops, or is lessened.

In S28, the member to be cooled is steadily cooled by the cooling apparatus. In preparation for a case in which there is a defect in the temperature sensor placed at the second height, and the detection of the liquid surface at the second height fails, a detector which detects overflow is provided. When an elapsed time from a point in time at which the output signal from the temperature sensor placed at the second height becomes lower than a threshold exceeds a predetermined time, in S24, a supply error is judged, and the supply of the liquid coolant may be stopped. In addition, the supply error may be judged in S24 and the supply of the liquid coolant may be stopped also in the case where the liquid surface is not detected at the second height even after a predetermined time has elapsed from the start of supply of liquid nitrogen.

In the case in which an uncertain amount of liquid coolant remains in the tank in the initial state also, the spontaneous bumping may be caused through the above-described control.

FIG. 5 shows at an upper part a change of the temperature during the cooling preparation process. The horizontal axis is a time axis, and the vertical axis is a temperature axis. Reference numeral 84 shows a temperature detected by a temperature sensor provided at a first height (lower-side temperature sensor), and reference numeral 86 shows a temperature detected by a temperature sensor provided at a second height (upper-side temperature sensor). A parameter Ta shows a boiling point of the liquid coolant under the atmospheric pressure.

FIG. 5 shows at a lower part a change of the pressure in the tank during the cooling preparation process. The horizontal axis is the time axis, and the vertical axis is a pressure axis. D1 shows an injection period (first period), and D2 shows a subsequent period following the injection period D1 (second period). A parameter pa shows the atmospheric pressure.

In a state in which the vacuum pump is operating, the open/close valve is opened at time t0. With this process, the pressure in the tank changes from the initial pressure (atmospheric pressure) to the first pressure (negative pressure). As a consequence, supply of the liquid coolant into the tank is started. That is, in a state in which the liquid coolant in the external container experiences the atmospheric pressure, when the pressure in the tank becomes the first pressure lower than the atmospheric pressure, due to a pressure difference, the liquid coolant in the external container starts to move into the tank via the supply pipe. The pressure in the tank is maintained at the first pressure. A gas suctioning force, a weight of liquid nitrogen in the supply pipe 20, and the flow path resistance of the supply pipe 20 contribute to the formation and the maintenance of the first pressure.

In a state in which the supply pipe and the tank are not sufficiently cooled, first, the liquid coolant in the pipe vigorously boils, and then, the liquid coolant in the tank boils vigorously. After liquid nitrogen or the nitrogen gas starts to enter the tank from the external container, the temperature detected by the lower-side temperature sensor is rapidly reduced, and, at a slightly later time, the temperature detected by the upper-side temperature sensor is rapidly reduced.

In a period t1, as described above, vigorous boiling is caused in the tank (refer to reference numeral 88). In the period t1, due to a rapid increase of thermal conductivity in the process of the tank (in particular the bottom wall) and the heat conducting member reaching a very low temperature, the inflow of the heat into the tank rapidly increases. As a result, an initial bumping 90 is caused. When a thermal capacity of the member to be cooled is relatively large, and the member to be cooled is not sufficiently cooled, the inflow of the heat is large, and film boiling may be caused, exceeding nucleate boiling. When liquid nitrogen is supplied to a tank which is empty at a normal temperature, the initial bumping 90 tends to be easily caused. On the other hand, when some amount of liquid nitrogen remains in the tank and the tank is cooled, such an initial bumping 90 tends to not occur easily.

If the initial bumping is caused after a large amount of liquid nitrogen is stored in the tank, in particular, after the tank reaches a full state, liquid nitrogen overflows from the tank, resulting in waste of liquid nitrogen. Therefore, the flow rate or the like is adjusted so that the initial bumping is caused before the inside of the tank becomes full.

After the occurrence of the initial bumping 90, the amount of heat flowing into liquid nitrogen in the tank is relatively large, and boiling (nucleate boiling) of liquid nitrogen is continued.

At time t2, following the lower-side temperature sensor, the detected temperature of the upper-side temperature sensor also becomes lower than the boiling point Ta of the liquid coolant under the atmospheric pressure. The detected temperatures of the two temperature sensors respectively show actual boiling points of the liquid coolant at the corresponding heights. At the time t2, when the liquid surface of the liquid coolant is detected by the upper-side temperature sensor, the open/close valve is closed at a timing t3 after a predetermined time has elapsed from the detection of the liquid surface, and the pressure in the tank is switched from the first pressure (negative pressure) to the second pressure (atmospheric pressure). With this process, the supply of the liquid coolant into the tank is stopped. The bubbles in the liquid coolant liquefy at the time of the increase in the pressure.

In general, the detected temperature of the upper-side temperature sensor is higher than the detected temperature of the lower-side temperature sensor. This is because, when the liquid nitrogen in the tank is not stirred so significantly, liquid nitrogen having a lower temperature is heavier than liquid nitrogen having a higher temperature.

In a period t4, the inflow of the heat from the outside is continued, but, because the temperature of the liquid coolant in the tank is lower than the boiling point of the liquid coolant under the atmospheric pressure, the liquid coolant basically does not boil, and settles. However, the temperature of liquid nitrogen gradually increases due to the heat flowing in from the outside, and approaches the boiling point of liquid nitrogen under the atmospheric pressure. At time t5, the temperature detected by the upper-side temperature sensor has reached the boiling point of liquid nitrogen under the atmospheric pressure.

Then, at the time t5, the temperature of liquid nitrogen reaches the boiling point on the inner surface of the tank at an upper part thereof. However, because the inflow of the heat is relatively gradual, liquid nitrogen does not immediately boil, and a part of liquid nitrogen is placed in the overheated state. Under such a situation, with a small vibration or the like as a trigger, the part of liquid nitrogen in the overheated state vaporizes at once. Specifically, in the illustrated example configuration, spontaneous bumping 92 occurs a plurality of times from a period t6 to a period t8. At time t7, the temperature detected by the lower-side temperature sensor has reached the boiling point of liquid nitrogen under the atmospheric pressure.

At time t9, spontaneous bumping 94 for a last time is caused. The spontaneous bumping 94 occurs after the temperature detected by the lower-side temperature sensor has reached the boiling point of liquid nitrogen under the atmospheric pressure. The last spontaneous bumping 94 is a relatively large bumping. After the occurrence of the last spontaneous bumping 94, no spontaneous bumping occurs. Each individual spontaneous bumping, in particular, the last, large spontaneous bumping 94, results in a large pressure increase in a short period of time in the tank. Due to each individual spontaneous bumping, in particular, the last, large spontaneous bumping 94, the bubbles in the cavities on the inner surface of the tank liquefy. That is, the cavities are deactivated. A parameter pb in FIG. 5 shows a pressure threshold. The cavities are effectively deactivated when a pressure increase exceeding pb is caused. As described above, the value of pb is 0.005 MPa (0.05 atmospheres), but the value may change according to various conditions. For example, the value of pb may be set to 0.003 MPa (0.03 atmospheres), or to 0.007 MPa (0.07 atmospheres).

In order to deactivate the cavities and to maintain this state with the last, large spontaneous bumping 94, desirably, thermal equilibrium is reached between the tank and the member to be cooled, before the last spontaneous bumping 94 occurs. For example, if the thermal equilibrium is reached between the tank and the member to be cooled after 45 minutes has elapsed from the start of the supply of liquid nitrogen, various conditions should be determined such that the last spontaneous bumping 94 occurs later than the elapsed time of 45 minutes. The flow rate may be adjusted by the flow rate adjustment valve so that such conditions are satisfied. For example, when the flow rate is increased; that is, when a release velocity is increased, the flow path resistance of the supply pipe is increased, and, as a consequence, the first pressure is further lowered, and the temperature of liquid nitrogen in the tank is further reduced. In this case, the time for the temperature of liquid nitrogen to reach the boiling point of liquid nitrogen under the atmospheric pressure after the supply of liquid nitrogen is stopped can be delayed. However, if the temperature of liquid nitrogen is reduced excessively, there is a possibility that liquid nitrogen freezes when the pressure in the tank is returned to the atmospheric pressure. Desirably, the temperature of liquid nitrogen is adjusted so as to avoid such a problem.

After the period t8, the inflow of the heat into the tank continues, and the boiling of liquid nitrogen in the tank continues. However, after the thermal equilibrium has been reached between the tank and the member to be cooled, the heat flowing into the upper part of the tank becomes dominant. Therefore, liquid nitrogen boils mostly at the upper part in the tank, more specifically, of the inner surface of the tank, at a location near the liquid surface. A vibration caused by the bubble generated near the liquid surface is smaller than a vibration caused by the bubble generated at the lower part of the tank, and a dynamical influence on the tank is smaller. Because heat is taken away by the evaporation of the liquid coolant at the liquid surface, there is a possibility that the boiling stopped state continues for a certain extent.

In experiments, it has been confirmed that, with reference to the supply start time of liquid nitrogen, the thermal equilibrium was reached after elapse of 45 minutes, and last spontaneous bumping later occurred after elapse of 65 minutes. Then, a low vibration state was caused, and was maintained for a long period of time until liquid nitrogen in the tank was exhausted.

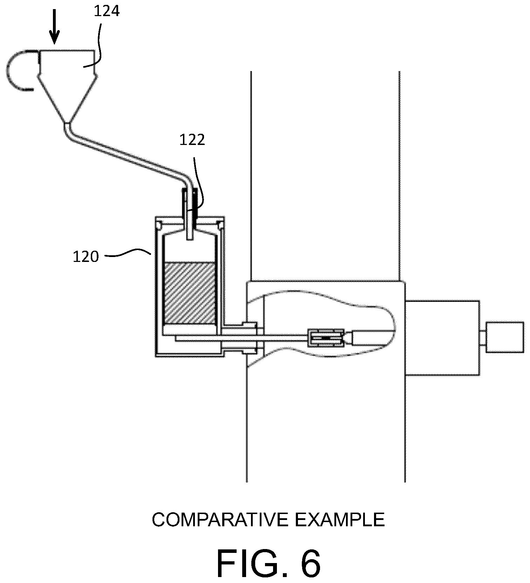

FIG. 6 shows a comparative example. A cooling apparatus of the comparative example is connected to a transmission electron microscope. The cooling apparatus has a tank 120. When liquid nitrogen is injected into the tank 120, a funnel 124 is used. The funnel 124 and a connection portion 122 of the tank 120 are connected with each other via a bent pipe. In this state, liquid nitrogen is injected into the funnel 124. When the cooling apparatus of the comparative example is used, the injection operation of liquid nitrogen must be performed at a high location, and the burden of the operation is high.

In the contrary, according to the cooling apparatus and cooling preparation method according to the embodiment of the present disclosure, the injection operation at the high location is not necessary, and, thus, the degree of safety of the worker can be improved, and the burden of the operation can be reduced. However, the deactivation of the cavities due to spontaneous bumping may be caused regardless of the placement position of the external container. In the embodiment of the present disclosure, the cooling apparatus is connected to the member to be cooled in the transmission electron microscope, but alternatively, the cooling apparatus may be connected to a member to be cooled in another apparatus. The spontaneous bumping may be caused in the liquid coolant by reducing the pressure in the tank during or after the injection of liquid nitrogen, and then increasing the pressure in the tank.

## Claims

1. A cooling apparatus (10) comprising:
a tank (12) connected to a member to be cooled via a heat conducting member (18); and
a pressure control equipment (16) that includes a pump (32) which suctions gas in the tank (12), and that sets a pressure in the tank (12) to a first pressure during a first period in which a liquid coolant is injected into the tank (12), and sets the pressure in the tank (12) to a second pressure higher than the first pressure during a second period subsequent to the first period, so that spontaneous bumping is caused in the liquid coolant in the tank (12) during the second period.

2. The cooling apparatus (10) according to claim 1, wherein
the first pressure is a pressure lower than an atmospheric pressure.

3. The cooling apparatus (10) according to claim 2, wherein
the second pressure is the atmospheric pressure.

4. The cooling apparatus (10) according to any preceding claim, further comprising:
a sensor (46) that detects a liquid surface height of the liquid coolant in the tank (12), wherein
the pressure control equipment (16) determines a timing of changing the pressure in the tank (12) to the second pressure based on an output signal of the sensor (46).

5. The cooling apparatus (10) according to any preceding claim, further comprising:
an external container (14) into which the liquid coolant is injected; and
a supply pipe (20) through which the liquid coolant in the external container is sent to the tank (12), wherein
the first pressure is a pressure lower than an atmospheric pressure, and
the liquid coolant in the external container (14) is introduced into the tank (12) via the supply pipe (20) during the first period.

6. The cooling apparatus (10) according to claim 5, wherein
the external container (14) is placed at a position lower than the tank (12).

7. The cooling apparatus (10) according to claim 5, wherein
a porous member (54) is provided at an intake port of the supply pipe (20).

8. The cooling apparatus (10) according to any preceding claim, wherein
the pressure control equipment (16) includes:
a suctioning pipe (22) provided between the pump (32) and the tank (12); and
a detector (62) which detects a temperature at a detection position on the suctioning pipe (22), and
overflow of the liquid coolant from the tank (12) is judged based on the temperature detected by the detector (62).

9. The cooling apparatus (10) according to any preceding claim, wherein
the pressure control equipment (16) includes a relief valve which operates when the pressure in the tank (12) has reached a predetermined pressure.

10. A cooling preparation method, comprising:
a first step (S18) of reducing a pressure in a tank (12) connected to a member to be cooled via a heat conducting member (18) from an initial pressure to a first pressure, to thereby lower a boiling point of a liquid coolant injected into the tank (12);
a second step (S22) of increasing, after the first step (S18), the pressure in the tank (12) from the first pressure to a second pressure, to thereby increase the boiling point of the liquid coolant in the tank (12); and
a third step (S26) in which, after the second step, spontaneous bumping is caused in the liquid coolant in the tank (12) with an increase of a temperature of the liquid coolant in the tank (12), so that bubbles in the liquid coolant in the tank (12) liquefy.
